# FASCICULE DE BREVET EUROPEEN

(11) **EP 0 362 081 B1**
(45) Date de publication et mention de la délivrance du brevet: **30.11.1994**
(21) Numéro de dépôt: 89420326.4
(22) Date de dépôt: 06.09.1989
(51) Int. Cl.: H01L 21/60, H01L 21/90, H01L 21/3205

(54) **Procédé de formation autoalignée de siliciure de tungstène**
Verfahren zum Herstellen von selbstjustierendem Wolframlsilizid
Process for producing self-aligned tungsten silicide

(30) Priorité: 09.09.1988 FR 8812347
(43) Date de publication de la demande: 04.04.1990
(73) Titulaire: FRANCE TELECOM, 75015 Paris (FR)
(72) Inventeur: Torres, Joaquim, F-38950 Saint Martin Le Vinoux (FR); Palleau, Jean, F-38410 Uriage (FR); Bourhila, Noureddine, F-38130 Echirolles (FR)
(74) Mandataire: de Beaumont, Michel

(56) Documents cités:
- EP-A- 0 264 692
- PATENT ABSTRACTS OF JAPAN, vol. 11, no. 346, 12 novembre 1987 ; & JP-A-62 126 631
- PATENT ABSTRACTS OF JAPAN, vol. 12, no. 54, 18 février 1988 ; & JP-A-62 200 747
- S. MOSS et al.: "The chemistry of the Semiconductor Industry", 1987, pages 160, 260, Blackie & Son, Londres, GB.

## Description

Dans certaines techniques actuelles de fabrication de circuits intégrés, on souhaite transformer des surfaces apparentes de silicium en siliciure d'un métal réfractaire , par exemple, dans le cas de transistors MOS, on peut souhaiter réaliser cette opération à la surface des zones de grille en silicium polycristallin et des zones de drain et de source qui sont des régions dopées dans un substrat de silicium monocristallin.

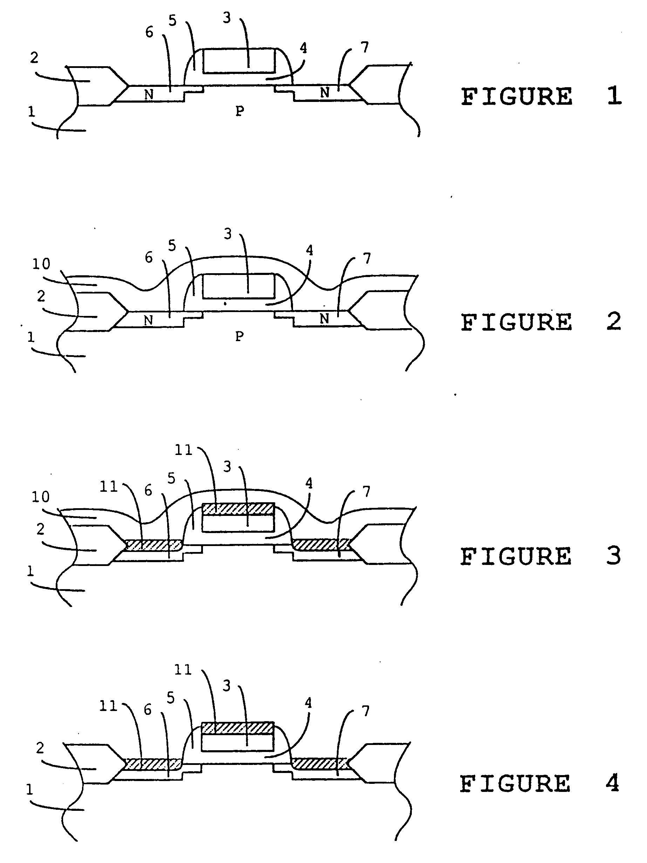

Un procédé classique pour réaliser cette opération va être décrit ci-après en relation avec les figures 1 à 4 dans le cas où le métal réfractaire est du tungstène.

La figure 1 représente une vue en coupe schématique d'une structure de transistor MOS à un stade intermédiaire de fabrication. La structure de la figure 1 est formée dans un substrat de silicium 1, dans une zone délimitée par des régions d'oxyde épais 2.

Le transistor MOS comprend une grille en silicium polycristallin 3 formée sur une couche d'oxyde de grille 4. Les bords de la grille sont isolés par une couche d'oxyde couramment appelée espaceur 5. Le drain et la source, 6 et 7, présentent dans la figure 1 une structure étagée du fait qu'ils sont formés en deux étapes, une première étape où c'est la région d'oxyde épais et la grille elle-même qui sert le masque et une deuxième étape dans laquelle c'est la grille élargie par les espaceurs qui sert de masque.

Si, à ce stade de la fabrication, on veut former une couche de siliciure de tungstène à la surface de la grille, de la source et du drain, on dépose uniformément une couche de tungstène 10 (figure 2) par exemple par pulvérisation cathodique. On procède ensuite à un traitement thermique entre 700 et 1000°C d'où il résulte que le tungstène réagit avec les surfaces apparentes de silicium pour former un siliciure de tungstène WSi₂, désigné par la référence 11 en figure 3. Ce traitement thermique est réalisé sous vide ou dans une athmosphère neutre vis à vis du tungstène.

Après cela, comme le représente la figure 4, on élimine par attaque sélective la couche de tungstène.

Ce procédé classique est intéressant puisqu'il n'utilise que des étapes simples à savoir un dépôt métallique uniforme, et qu'aucune étape de lithographie n'est nécessaire pour positionner le siliciure de tungstène.

Néanmoins, ce procédé est mal adapté au cas où les structures sont de très petites dimensions (dimension minimale inférieure au micromètre). En effet, l'extension, et notamment l'extension latérale, des régions de WSi₂ dépend du temps de recuit qui doit être contrôlé avec une grande précision. De plus, l'existence de petites zones d'oxyde natif sur les zones de silicium théoriquement dénudées entraîne une épaisseur inhomogène de la couche de siliciure de tungstène, le tungstène ne réagissant pas avec SiO₂, et, si l'on prolonge la réaction pour pallier cette difficulté, on accroît indûment l'extension latérale du siliciure de tungstène.

Les mêmes problèmes existent dans le cas du molybdène. Ils ont été partiellement résolus dans le cas du titane en prévoyant de faire réagir le titane avec de l'azote à pression atmosphérique pendant le recuit. Ce procédé conduit à une étape d'équilibre entre la formation de nitrure de titane et de silicium de titane et permet donc d'obtenir un état de fin de réaction bien défini. Toutefois, ce procédé n'a pas été envisagé pour le molybdène et le tungstène qui ne réagissent pas avec avec N₂ aux températures de recuit. En outre, dans le cas du titane, le procédé, mis en oeuvre sous pression ambiante, conduit à des couches de siliciure de titane plus minces qu'on ne le souhaiterait. Un autre procédé de formation de siliciures est décrite dans EP-A- 264692.

Un objet de la présente invention est de prévoir un procédé de formation localisée de siliciure de tungstène ou de molyb dène qui présente les mêmes avantages de simplicité que le procédé de l'art antérieur précédemment exposé en relation avec les figures 1 à 4 sans en présenter les inconvénients.

Pour atteindre cet objet, la présente invention prévoit un procédé de formation localisée de siliciure de tungstène ou de molybdène sur des régions apparentes de silicium d'une face d'une plaquette de silicium comportant également des régions oxydées, comprenant les étapes consistant à revêtir uniformément la plaquette d'une couche de tunsgtène ou de molybdène et à recuire à une température appropriée ; selon ce procédé, l'étape de recuit est effectuée en présence d'un gaz réactif tel que l'oxygène ou un composé de l'azote tel que NH₃. Le recuit est effectué à pression réduite du gaz réactif. Si l'on veut procéder à la pression atmosphérique, le gaz réactif est dilué dans un gaz porteur neutre.

Ces objets, caractéristiques et avantages de la présente invention seront exposés en relation avec les figures 1 à 4, qui ont déjà décrites précédemment dans le cadre de l'exposé de l'art antérieur.

Selon l'invention, on procède d'abord aux étapes amenant à la structure illustrée en figure 2. Toutefois, selon la présente invention, au lieu de procéder à un recuit sous vide ou sous atmosphère neutre on procède à ce recuit en présence d'une atmosphère contenant un gaz susceptible de réagir avec le tungstène tel que l'oxygène ou un composé d'azote se décomposant dans la plage de température concernée pour donner de l'azote atomique, tel que NH₃. Ainsi, pendant le recuit, tandis que le tungstène réagit avec le silicium pour former les couches 11 illustrées en figure 3, ce tungstène se combine avec l'oxygène ou l'azote pour former un composé du type WOₓ ou WNₓ.

Un avantage important de l'invention est que, une fois que la couche de tungstène a été complètement transformée, d'une part en WSi₂ d'autre part en WOₓ ou WNₓ, on arrive à un état d'équilibre qui n'évolue plus même si le recuit se poursuit.

Dans le cas général, la formation du composé WNₓ (WOₓ) est beaucoup plus rapide que la formation de WSi₂. Par exemple, si l'on opérait à pression ambiante avec de l'oxygène pur ou NH₃ pur, pratiquement toute l'épaisseur de la couche de tungstène serait transformée en WOₓ (ou WNₓ). Pour arriver à l'obtention d'une épaisseur de WSi₂ choisie à l'avance, on freine la réaction de W avec le gaz de l'atmosphère de recuit (NH₃ ou O₂) ou bien en réduisant la pression de gaz dans l'enceinte de recuit ou bien en diluant le gaz réagissant avec le tungstène dans un gaz neutre si l'on préfère procéder à pression atmosphérique. Dans des réalisations pratiques, on est amené à choisir des pressions partielles inférieures au torr (102 pascals). Le réglage de cette pression partielle, et c'est là un des aspects de la présente invention, permet de déterminer l'épaisseur de la couche de siliciure de tungstène que l'on cherche à obtenir. Il en serait de même dans le cas du molybdène et même du titane.

Pour l'étape finale illustrée en figure 4, on pourra prendre tout produit gravant WNₓ ou WOₓ sélectivement par rapport à SiO₂, Si et WSi₂. Un produit satisfaisant est par exemple le ferricyanure de potassium.

La présente invention est susceptible de nombreuses variantes, notamment en ce qui concerne le gaz permettant de créer un composé avec le tungstène ou le molybdène. Ce peut être un gaz à base d'oxygène tel que de l'oxygène pur ou de l'air, ou un gaz à base d'azote tel que NH₃. Les exemples de l'invention ont plus particulièrement concerné le tungstène mais l'invention s'applique de la même manière au molybdène.

## Revendications

1. Procédé de formation localisée de siliciure de tungstène ou de molybdène sur des régions apparentes de silicium (6) d'une face d'une plaquette de silicium (1) comportant également des régions oxydées comprenant les étapes consistant à revêtir uniformément la plaquette d'une couche de tunsgtène (10) ou de molybdène et à recuire à une température de l'ordre de 700°C à 1000°C, ce procédé comprenant ensuite l'étape d'élimination par attaque sélective dudit composé,
caractérisé en ce que l'étape de recuit est effectuée en présence d'un gaz à faible pression formant avec le tungstène ou le molybdène un composé chimique.

2. Procédé selon la revendication 1, caractérisé en ce que ledit gaz est de l'oxygène.

3. Procédé selon la revendication 1, caractérisé en ce que ledit gaz est un composé de l'azote tel que NH₃ se décomposant dans la plage de température concernée pour donner de l'azote atomique.

4. Procédé selon l'une quelconque des revendications 1 à 3, caractérisé en ce que, pendant le recuit, la pression partielle dudit gaz est inférieure à 10² pascals.

5. Procédé selon la revendication 4, caractérisé en ce que le recuit est effectué à la pression atmosphérique, ledit gaz étant dilué dans un gaz porteur neutre.

6. Procédé selon la revendication 3, caractérisé en ce que le nitrure ou l'oxyde de tungstène ou de molybdène formé est gravé sélectivement par un ferricyanure.

## Patentansprüche

1. Verfahren zum lokalisierten Herstellen von Wolfram- oder Molybdän-Silizid auf freien Siliciumbereichen (6) auf einer Oberfläche eines Siliciumplättchens (1), welches ebenfalls oxidierte Bereiche aufweist, wobei Schritte vorgesehen sind, das Plättchen gleichmäßig mit einer Wolfram- oder Molybdänschicht (10) zu bedecken und bei einer Temperatur im Bereich von 700°C bis 1000°C zu sintern, und das Verfahren anschließend einen Entfernungsschritt durch selektives Ätzen dieser Verbindung aufweist, dadurch gekennzeichnet, daß der Sinterschritt in Gegenwart eines Gases mit niedrigem Druck ausgeführt wird, welches mit dem Wolfram oder dem Molybdän eine chemische Verbindung bildet.

2. Verfahren nach Anspruch 1, dadurch gekennzeichnet, daß das Gas Sauerstoff ist.

3. Verfahren nach Anspruch 1, dadurch gekennzeichnet, daß das Gas eine Stickstoffverbindung, wie NH₃ ist, die sich in dem betreffenden Temperaturbereich zersetzt, um atomaren Stickstoff zu liefern.

4. Verfahren nach einem der Ansprüche 1 bis 3, dadurch gekennzeichnet, daß während des Sinterns der Partialdruck des Gases niedriger als 10² Pascal ist.

5. Verfahren nach Anspruch 4, dadurch gekennzeichnet, daß das Sintern bei Atmosphärendruck ausgeführt wird und das Gas in einem neutralen Trägergas gelöst ist.

6. Verfahren nach Anspruch 3, dadurch gekennzeichnet, daß das gebildete Nitrid bzw. Oxid von Wolfram oder Molybdän selektiv mit Eisenzyanid geätzt wird.

## Claims

1. A process of forming self-aligned tungsten or molybdenum silicide on silicon apparent regions (6) of a silicon wafer surface (1) also including oxidized regions, comprising the steps consisting in uniformly coating the wafer with a tungsten or molybdenum layer (10) and annealing at a temperature ranging from 700°C to 1000°C, said process then comprising a removal step by means of selective etching of said composite, characterized in that the annealing step is carried out in the presence of a low pressure gas forming with tungsten or molybdenum a chemical composite.

2. A process according to claim 1, characterized in that said gas is oxygen.

3. A process according to claim 1, characterized in that said gas is a nitrogen composite such as NH₃ which decomposes within the appropriate temperature range for forming atomic nitrogen.

4. A process according to any of claims 1 to 3, characterized in that, during the annealing process, the partial pressure of said gas is lower than 10² pascals.

5. A process according to claim 4, characterized in that the annealing process is carried out under atmospheric pressure conditions, said gas being diluted in a neutral carrier gas.

6. A process according to claim 3, characterized in that the formed nitride or oxide of tungsten or molybdenum is selectively etched by a ferricyanide.
